# EUROPEAN PATENT SPECIFICATION

(11) **EP 4 046 004 B1**
(45) Date of publication and mention of the grant of the patent: **28.01.2026**
(21) Application number: 19949321.4
(22) Date of filing: 14.10.2019
(51) Int. Cl.: G06F 3/03, G06F 3/0484, G06F 30/13, G05B 19/418

(54) **GENERATING A 3D MODEL OF A PLANT LAYOUT**
ERZEUGUNG EINES 3D-MODELLS EINES ANLAGENLAYOUTS
GÉNÉRATION D'UN MODÈLE TRIDIMENSIONNEL (3D) D'UNE IMPLANTATION D'USINE

(43) Date of publication of application: 24.08.2022
(73) Proprietor: Siemens Industry Software Ltd., 7019900 Airport City (IL)
(72) Inventor: MANN, Zachi, 7680400 Mazkeret Batya (IL); SHAI, Omri, 7630517 Rehovot (IL); ZULER, Shahar, 4840931 Rosh Haayin (IL)
(74) Representative: Siemens Patent Attorneys
(86) International application number: PCT/IB2019/058729
(87) International publication number: WO 2021/074665

(56) References cited:
- EP-A1- 3 506 211
- AU-A1- 2013 260 723
- US-A1- 2017 053 538
- US-A1- 2018 293 664
- XUETAO YIN ET AL: "Generating 3D Building Models from Architectural Drawings: A Survey", IEEE COMPUTER GRAPHICS AND APPLICATIONS, IEEE SERVICE CENTER, NEW YORK, NY, US, vol. 29, no. 1, 1 January 2009 (2009-01-01), pages 20 - 30, XP011241089, ISSN: 0272-1716, DOI: 10.1109/MCG.2009.9

## Description

### TECHNICAL FIELD

The present disclosure is directed, in general, to computer-aided design, visualization, and manufacturing ("CAD") systems, product lifecycle management ("PLM") systems, product data management ("PDM") systems, and similar systems, that manage data for products and other items (collectively, "Product Data Management" systems or PDM systems).

### BACKGROUND OF THE DISCLOSURE

In factory design, three-dimensional ("3D") digital models of manufacturing plants and facilities are used for a variety of manufacturing planning purposes. Examples of such usages includes, but are not limited by, manufacturing process analysis, manufacturing process simulation, equipment collision checks and virtual commissioning.

As used herein the terms "plant layout" denote an arrangement of a plurality of plant objects such as e.g. machinery, equipment, furniture, walls and other plant assets.

As used herein the terms "plant layout" may denote a layout of a plant or a layout of any portion of a plant.

For production line builders and system integrators, the phase of 3D digital modeling of the plant-layout is cumbersome and time consuming.

Layout planners typically receive as input a two-dimensional ("2D") plant-layout schema. The 2D plant-layout schema may be in a digital format for example as a drawing image or as a file from 2D Computer Aided Design ("CAD") software applications such as Autocad and MicroStation, or sometimes even in a hardcopy format such as plain paper printouts.

Typically, on the basis of the received 2D plant-layout drawing or schema, layout planners have then to browse a plant component library, find suitable 3D plant objects for each schema and position the 3D plant object based on the received 2D plant-layout schema. In some prior art techniques, layout planners are assisted in their 3D modeling tasks by being able to reutilize specific 2D sub-drawings and obtain corresponding connected 3D sub-models.

State of the art techniques assisting the layout planners in their 3D modeling tasks often require that all data preparation of the 2D and 3D CAD objects and their libraries is done using the same CAD tool.

Unfortunately, this is not the usual scenario that layout planners are typically facing. In fact, as mentioned above, layout planners often receive 2D plant-layout schemas as files or drawings generated from a large variety of different standard and non-standard CAD tools, and sometimes even in a hardcopy drawing format.

Therefore, techniques for generating a 3D plant-layout model which are agnostic of the format of the 2D plant-layout schema are desirable.
EP 3 506 211 A1 relates to the conversion of two-dimensional (2D) floor plans into three-dimensional (3D) building models.
AU 2013 260 723 A1 primarily involves a panoptic visualization system.
US 2017/053538 A1 relates to a multi-sensor data collection, analysis, recognition, and visualization system, primarily in the context of navigation-capable vehicles or platforms.

### SUMMARY OF THE DISCLOSURE

The invention is defined by the appended claims.

Various disclosed embodiments include methods, systems, and computer readable mediums for generating a 3D-model of a plant layout departing from a 2D-schema of the plant-layout. The plant-layout model comprises an arrangement of a plurality of plant objects and is representable by a 2D-schema and by a 3D model. The plant-layout 2D schema comprises a 2D arrangement of a plurality of 2D plant objects and the plant-layout 3D model comprises a 3D arrangement of a plurality of 3D plant objects.

A method includes providing access to a plant catalogue of a plurality of identifiers of a plurality of 3D plant objects, wherein at least one of the 3D plant object identifiers is associated to an identifier of a corresponding 2D plant object. The method includes receiving data on a given 2D schema of a plant-layout as input data. The method includes applying a function trained by a machine learning algorithm to the input data for detecting a set of 2D plant objects, wherein a set of identifier and location data on the detected 2D plant object set is provide as output data. The method includes selecting a set of 3D plant objects from the plant catalogue whose identifiers are associated to the set of 2D plant objects identifiers of the output data. The method includes generating a 3D model of the plant-layout by arranging the selected set of 3D plant objects in accordance with the corresponding location data of the output data.

Various disclosed embodiments include methods, systems, and computer readable mediums for providing a function trained by a machine learning algorithm for generating a 3D-model of a plant layout. A method includes receiving as input training data a plurality of 2D plant-layout schemas each one comprising a 2D arrangement of a plurality of 2D plant objects. A method includes receiving, for each 2D plant-layout schema, receiving, as output training data, identifiers and location data associated to one or more of the plurality of 2D plant objects. The method includes training by a machine learning algorithm a function based on the input training data and on the output training data. The method includes providing the trained function for generating a 3D model of a plant-layout.

Various disclosed embodiments include methods, systems, and computer readable mediums for generating a 3D-model of a plant layout departing from a 2D-schema of the plant-layout. The plant-layout model comprises an arrangement of a plurality of plant objects and is representable by a 2D-schema and by a 3D model. The plant-layout 2D schema comprises a 2D arrangement of a plurality of 2D plant objects and the plant-layout 3D model comprises a 3D arrangement of a plurality of 3D plant objects. A method includes providing access to a plant catalogue of a plurality of identifiers of a plurality of 3D plant objects, wherein at least one of the 3D plant object identifiers is associated to an identifier of a corresponding 2D plant object. The method includes receiving as input training data a plurality of 2D plant-layout schemas each one comprising a 2D arrangement of a plurality of 2D plant objects The method includes for each 2D plant-layout schema, receiving, as output training data, identifiers and location data associated to one or more of the plurality of 2D plant objects. The method includes training by a machine learning algorithm a function based on the input training data and on the output training data. The method includes providing the trained function for generating a 3D model of a plant-layout. The method includes generating a 3D model of a plant layout by applying the trained function to a given 2D schema of a plant-layout as input data.

Before undertaking the DETAILED DESCRIPTION below, it may be advantageous to set forth definitions of certain words or phrases used throughout this patent document: the terms "include" and "comprise," as well as derivatives thereof, mean inclusion without limitation; the term "or" is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, whether such a device is implemented in hardware, firmware, software or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates a block diagram of a data processing system in which an embodiment can be implemented.
Figure 2 is a drawing schematically illustrating an example of a 2D schema image of a 2D plant layout in accordance with example embodiments.
Figure 3 is a drawing schematically illustrating examples of tagged objects of the 2D schema of Figure 1 in accordance with example embodiments.
Figure 4 is a drawing schematically illustrating a screenshot of a generated 3D model of a plant layout in accordance with example embodiments.
Figure 5 illustrates a flowchart for generating a 3D model of a plant layout in accordance with disclosed embodiments.

### DETAILED DESCRIPTION

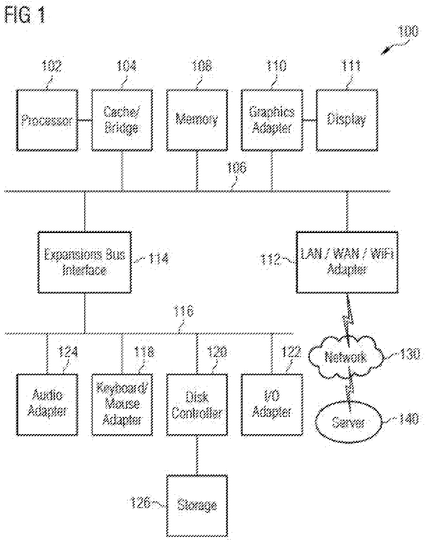

FIGURES 1 through 5, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

Previous techniques for generating a 3D model of a plant layout departing from a 2D schema of the plant layout have some drawbacks. The embodiments disclosed herein provide numerous technical benefits, including but not limited to the following examples.

Embodiments enable automatic generation of a 3D CAD model of a plant layout departing from its 2D schema without required human intervention by the plant layout engineer.

Embodiments render the process of generating a 3D model of plant layout more efficient.

Embodiments enable upgrading the capability of several existing manufacturing planning software applications.

Embodiments enable time savings.

Embodiments allow providing to layout planners a Software as a Service ("SaaS") module whereby they can upload a 2D layout schema and get as result a populated 3D digital scene where plant equipment objects are automatically positioned.

Figure 1 illustrates a block diagram of a data processing system 100 in which an embodiment can be implemented, for example as a PDM system particularly configured by software or otherwise to perform the processes as described herein, and in particular as each one of a plurality of interconnected and communicating systems as described herein. The data processing system 100 illustrated can include a processor 102 connected to a level two cache/bridge 104, which is connected in turn to a local system bus 106. Local system bus 106 may be, for example, a peripheral component interconnect (PCI) architecture bus. Also connected to local system bus in the illustrated example are a main memory 108 and a graphics adapter 110. The graphics adapter 110 may be connected to display 111.

Other peripherals, such as local area network (LAN) / Wide Area Network / Wireless (e.g. WiFi) adapter 112, may also be connected to local system bus 106. Expansion bus interface 114 connects local system bus 106 to input/output (I/O) bus 116. I/O bus 116 is connected to keyboard/mouse adapter 118, disk controller 120, and I/O adapter 122. Disk controller 120 can be connected to a storage 126, which can be any suitable machine usable or machine readable storage medium, including but are not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices.

Also connected to I/O bus 116 in the example shown is audio adapter 124, to which speakers (not shown) may be connected for playing sounds. Keyboard/mouse adapter 118 provides a connection for a pointing device (not shown), such as a mouse, trackball, trackpointer, touchscreen, etc.

Those of ordinary skill in the art will appreciate that the hardware illustrated in Figure 1 may vary for particular implementations. For example, other peripheral devices, such as an optical disk drive and the like, also may be used in addition or in place of the hardware illustrated. The illustrated example is provided for the purpose of explanation only and is not meant to imply architectural limitations with respect to the present disclosure.

A data processing system in accordance with an embodiment of the present disclosure can include an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows^{™}, a product of Microsoft Corporation located in Redmond, Wash. may be employed if suitably modified. The operating system is modified or created in accordance with the present disclosure as described.

LAN/ WAN/Wireless adapter 112 can be connected to a network 130 (not a part of data processing system 100), which can be any public or private data processing system network or combination of networks, as known to those of skill in the art, including the Internet. Data processing system 100 can communicate over network 130 with server system 140, which is also not part of data processing system 100, but can be implemented, for example, as a separate data processing system 100.

Embodiments include one or more of the following steps:
- preparing of input and output training data:
- training a Machine Learning ("ML") function;
- applying a functioned trained by a ML algorithm;
- generating a 3D model of the plant layout;
- adjusting the 3D model by applying received additional layout data including Manufacturing Process Semantics ("MPS") information;

### Example embodiments of preparing of input and output training data

In embodiments, input training data and output training data are prepared for training a function by a ML algorithm.

As input training data, a plurality of 2D schemas of a plurality of plant layouts are generated with standard CAD software tools. The generated plant-layout schema drawings include a set of standardized plant object icons and schema annotations in form of text and shapes. In embodiments, data of the 2D schemas are preferably provided in a digital image format. In other embodiments, when data of the 2D schemas are provided in other non-images formats (e.g. DXF or other CAD file formats), such data are converted into a digital image format.

As output training data, for each generated 2D schema, a set of bounding boxes around each plant object icon is automatically or manually generated with CAD software tools. The bounding boxes are preferably rectangles around the plant objects with a label identifying the type of plant objects. The rectangle position identifies the object position.

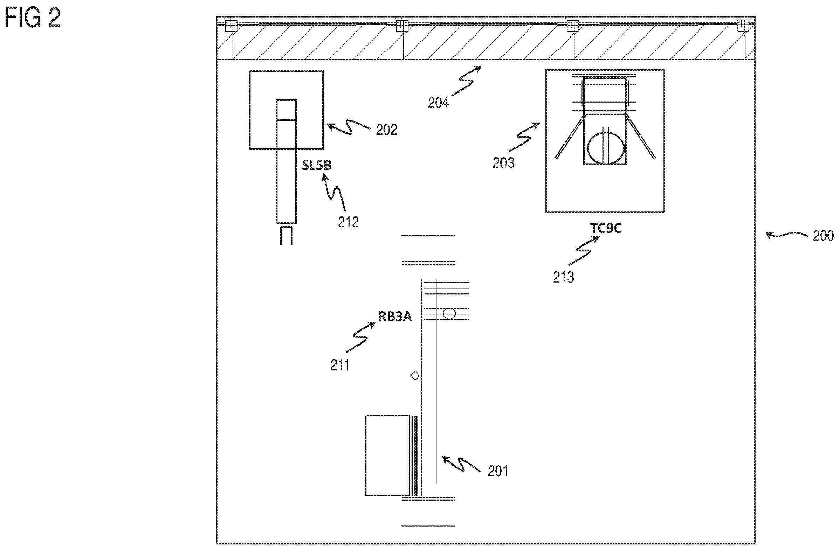

Figure 2 is a drawing schematically illustrating an example of a 2D schema image of a 2D plant layout in accordance with example embodiments. The 2D schema 200 of the plant layout of Figure 2 may serve to illustrate an example embodiment of a generated 2D schema of prepared input training data of a ML algorithm for object detection.

The 2D schema drawing of Figure 2 generated with a CAD software tool shows a simplified arrangement of a plant layout with a robot, a sealer, a tool changer and a wall. The 2D schema 200 representing the plant layout includes a corresponding arrangement of 2D plant object icons: a robot icon 201, a sealer icon 202, a tool changer icon 203 and a wall icon 204. The plant object icons 201, 202, 203, 204 include corresponding schema annotations 211, 212, 213 with schema information on the model of robot RB3A, on the model of sealer SL5B and on the model of tool changer TC9C. In other embodiments, other schema information may be conveyed via the schema annotation. Example of schema information include, but are not limited to, Product Manufacturing Information ("PMI"), information on equipment vendors and models, information on units, information on measurements like e.g. distance from wall, information on scales and other relevant schema information.

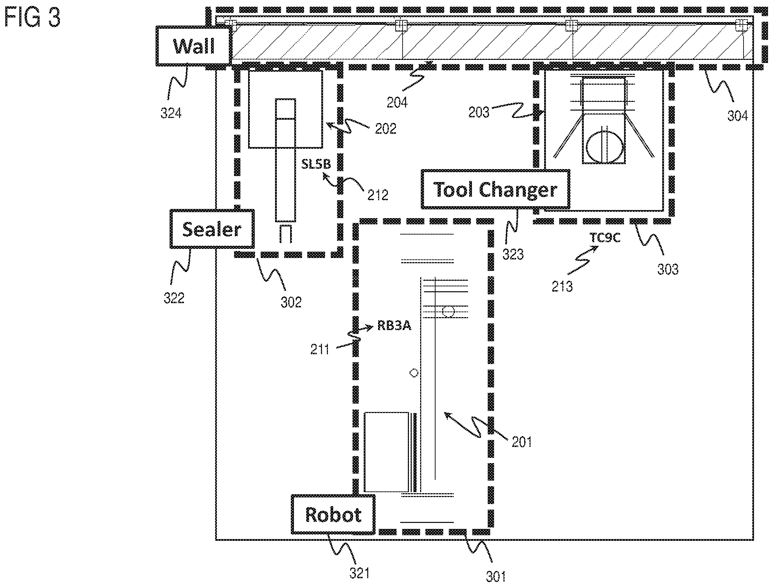

Figure 3 is a drawing schematically illustrating examples of tagged objects in the 2D schema of Figure 2 in accordance with example embodiments. The tagged objects of Figure 3 may serve to illustrate an example embodiment of prepared output training data.

In Figure 3, bounding boxes 301, 302, 3033, 304 are generated around each CAD object icon 201, 202, 203, 204 of Figure 2. Each bounding box 221, 222, 223, 224 has a label 231, 232, 233, 234 identifying the object type, respectively "Robot", "Sealer", "Tool Changer", and "Wall". The bounding boxes 301, 302, 303, 3044 and their labels 231, 232, 233, 234 are an example of prepared output training data of a ML algorithm for object detection.

Preferably, a large amount of input and output training data is automatically generated for training the ML function.

### Example embodiments of Machine Learning training

In embodiments, in case the format of the input training data is different than a digital image format, the input training data may conveniently be pre-processed to transform the input training data format into a digital image format. In embodiments, examples of pre-processing includes scanning a paper printout with the plant layout 2D schema or transforming a CAD file with the plant layout 2D schema into a digital image.

In embodiments, the output training data is pre-processed to generate output training data in a numerical format in which the output training data comprise a numerical object identifier and a set of coordinates defining the bounding box position.

Table 1 below shows an example embodiment of output training data in a numerical format.

The first column of Table 1 includes the identifiers of the plant object icons delimited by the corresponding bounding boxes. The remaining columns of Table 1 includes four coordinates for determining size and position of the bounding boxes according to YOLO requirements (x_center, y_center, width, height). Table 2 provides an example of association between the value of the object identifier and the corresponding label of the plant object.

**Table 1: example of bounding boxes in a numerical data format**

| Object identifier | Coordinate_1 | Coordinate_2 | Coordinate_3 | Coordinate_4 |
|---|---|---|---|---|
| 9 | 0.335677 | 0.195076 | 0.030729 | 0.301136 |
| 17 | 0.539062 | 0.380682 | 0.037500 | 0.060606 |
| 17 | 0.647396 | 0.595170 | 0.034375 | 0.072917 |
| 10 | 0.621615 | 0.594697 | 0.016146 | 0.054924 |
| 0 | 0.342708 | 0.194129 | 0.017708 | 0.299242 |
| 0 | 0.254948 | 0.296402 | 0.118229 | 0.030303 |
| 0 | 0.202344 | 0.457860 | 0.020313 | 0.358902 |
| 0 | 0.917133 | 0.802557 | 0.017708 | 0.330492 |
| 7 | 0.322656 | 0.286458 | 0.032813 | 0.108902 |
| 7 | 0.320333 | 0.859848 | 0.062500 | 0.058712 |
| 7 | 0.527033 | 0.883049 | 0.056250 | 0.055871 |
| 7 | 0.700781 | 0.950758 | 0.032813 | 0.093435 |
| 8 | 0.745573 | 0.783617 | 0.299479 | 0.098482 |
| 14 | 0.718750 | 0.685606 | 0.089533 | 0.125000 |
| 14 | 0.888802 | 0.669981 | 0.058854 | 0.086174 |
| 15 | 0.696094 | 0.611269 | 0.017188 | 0.023674 |
| 15 | 0.744792 | 0.611269 | 0.016667 | 0.025568 |
| 9 | 0.474479 | 0.748106 | 0.036458 | 0.147727 |
| 9 | 0.387240 | 0.902462 | 0.031771 | 0.096591 |
| 11 | 0.533073 | 0.948864 | 0.039062 | 0.066288 |
| 16 | 0.622917 | 0.665720 | 0.020833 | 0.085227 |
| 16 | 0.648698 | 0.668561 | 0.021354 | 0.071970 |

**Table 2: example of association between identifiers and labels of plant objects**

| Object identifier | Object label |
|---|---|
| 0 | Fence |
| 1 | Tool_changer |
| 2 | OverHead_conveyer |
| 3 | Robot |
| 4 | Turn_table |
| 5 | Assembly_rail |
| 6 | Robot_centroller |
| 7 | Electrical_cabinet |
| 8 | Fixture |
| 9 | Sealer |
| 10 | Tip_dresser |

It is noted that in the embodiment examples of Table 1 the coordinates of the bounding boxes are defined by four coordinates only. In fact, in this example embodiment, the boxes are assumed to be rectangular with sides parallel to the plant layout cell and no orientation is considered. In other embodiments, the object coordinates may be more than four and orientation of the bounding box may also be considered.

The input training data with the generated images with 2D schemas of plant layouts and the output training data with the data on the bounding boxes, e.g. position parameters and identifier, of the corresponding tagged plant objects are elaborated to train a ML function.

The tagged plant objects are used for training the ML algorithm for object detection. As used herein, the terms "object detection" denote determining the location on the image where certain objects are present as well as classifying those objects.

In embodiments, the desired data format of the input and output training data is obtained by applying one or more pre-processing steps on the data so as to transform the original data format into the desired data format.

In embodiments, the ML "algorithm is a deep learning algorithm preferably a convolutional neural network algorithm. An example of object detection system include, but is not limited by, You Only Look Once ("YOLO") algorithm.

In embodiments, the automatically generated and tagged images are used in order to train a dedicated neural network such as YOLO neural network. In embodiments, other types of ML object detection algorithms may be used.

In embodiments, the resulting data of the ML trained function are used to generate a module for detecting 2D plant objects from input data of a given 2D schema of a plant layout.

In embodiments, the training data may be stored at a local machine/server or in a remote location, e.g. in the the cloud. In embodiments, training data may be supplied by proprietary data sources or by public data sources or by a combination thereof. In embodiments, the training of the ML function may be done at a local machine/server or at a remote, e.g. in the cloud.

In embodiments, the training step may be done as a Software as a Service ("SaaS"), either on a local machine/server or on remote machine/server, e.g. in the cloud.

### Example embodiments of applying a function trained by a ML algorithm

In embodiments, the detection module may be used as a SaaS cloud service. In embodiment, the detection module may be used as a stand-alone module in a local site or in a remote location.

In embodiments, the detection module may be used as a stand-alone module by a manufacturing planning system. In other embodiments, the detection module may be embedded within a manufacturing planning system.

Data on a given 2D schema of a plant layout are received as input data. In embodiments, the 2D schema data are provided in form of a digital image of a 2D plant layout drawing. In other embodiments, the 2D schema of the plant layout may be provided in other formats e.g. as a CAD file or as a hardcopy printout and the data are pre-processed so as to obtain the desired digital image format.

The 2D schema includes a plurality of 2D plant objects, preferably in form of icons, representing a plurality of plant objects. In embodiments, at least one of the 2D plant objects is accompanied by a schema annotation in form of text and/or symbols including schema information. Example of schema information include, but are not limited to, Product Manufacturing Information ("PMI"), information on equipment vendors and models, information on units, information on measurements like e.g. distance from wall, information on scales and other relevant schema information.

Figure 2 is a drawing illustrating an example of a 2D schema image of a 2D plant layout in accordance with example embodiments. The 2D schema of the plant layout of Figure 2 may also illustrate an example embodiment of input data, e.g. a given 2D layout schema.

A plant catalogue or an access to the plant catalogue is provided. A plant catalogue of plant objects comprises identifiers of 3D plant objects, wherein at least one of the identifiers is associated to an identifier of a corresponding 2D plant object. In embodiments, examples of ways of implementing the association between 2D and 3D identifiers include, but are not limited by, table/key value pairs, json, xml, txt files with pairs of identifier index and path to the 3D CAD model.

In embodiments, a plant catalogue may be a library of 3D CAD models of plant objects with their associated 2D identifier index. The plant catalogue may be a standard one with plant objects which are widely used in an industry and it may be a specialistic plant catalogue with plant objects which are vendor and/or project specific.

The 2D digital images of the 2D schemas of the plant layout are analyzed by applying the function trained with the ML algorithm. The plant object types, bounding rectangles, positions are recognized inside the 2D layout schema by means of neural network inference.

Figure 3 is a drawing schematically illustrating examples of tagged objects in the 2D schema of Figure 1 in accordance with example embodiments. The tagged objects of Figure 3 may illustrate also an example embodiment of output data, where e.g. the bounding boxes 301, 302, 303, 304 and their labels 321, 322, 323, 324 illustrate an embodiment output data of an applied ML function.

### Example embodiments of generating a 3D model of the plant layout

In embodiments, the 3D models of the recognized plant objects are automatically selected from the associated plant catalogue, e.g. a ready-made 3D CAD library and/or a specific 3D CAD library supplied by the user. The 3D model of a recognized plant object is selected based on the 2D plant object type detected within the input 2D drawings.

The selected 3D models of the plant objects are populated in a 3D scene with position based on the position of the detected bounding boxes. Information on the orientation of the 3D models in case available from the bounding box coordinates may also be used. In embodiments, orientation information may be obtained by cropping the icon image inside the bounding box and by analyzing it to extract the orientation of the identified plant object.

In embodiments, schema information is extracted from the 2D schema drawings, for example via OCR from the schema annotation of the digital image or extracted from the CAD file when still available. In embodiments, the extracted schema information may be used to select the appropriate 3D model of a plant object, e.g. a specific model/type of a machine or a robot and/or it may be used to attach a payload and/or reposition or orientate the 3D model.

In other embodiments, the icon image inside the bounding box may be cropped and analyzed to determine the orientation of the plant object.

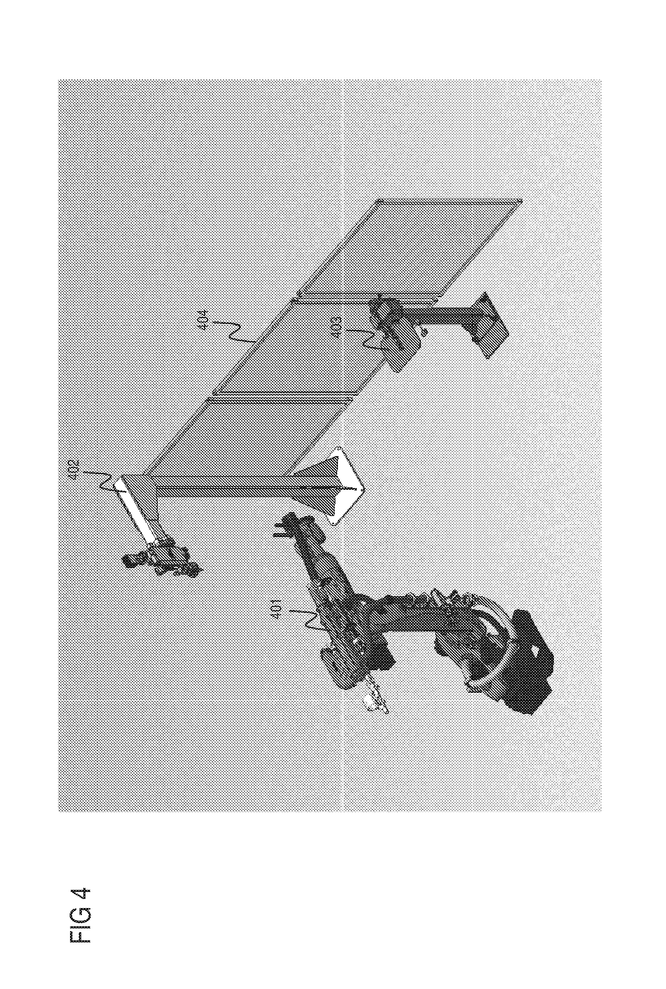

Figure 4 is a drawing schematically illustrating a screenshot of a generated 3D model of a plant layout in accordance with an example embodiment assuming that the input data is the 2D schema drawing of Figure 2. The 3D model of the plant layout in the 3D scene include an arrangement of 3D plant object models 401, 402, 403, 404 of a robot, a sealer, a tool changer and a wall.

### Examples embodiments of adjusting the 3D model by applying MPS information

In embodiments, additional layout data may be provided as for example data with information on scale of the drawings and/or data with "MPS" information. MPS information include manufacturing process information which may be used to improve the location and orientation accuracy of the plant objects and/or to add more details to the 3D model of the plant layout. Examples of MPS information include, but are not limited by, weld point parameter information, equipment payload information, electric constraints inofmration. In embodiments, additional layout data may be provided with access to a repository like a database, with data files such as e.g. JSON, csv, excel, xml, txt files or via external inputs in the shape of list of paths. In embodiments, MPS information may automatically be extracted from a data center of a PLM system as for example TeamCenter.

In embodiments, based on MPS information provided as additional layout data, the 3D model of the plant layout may conveniently be adjusted for example by inserting additional 3D objects to the 3D scene and/or by adjusting the position and orientation of the already arranged 3D plant objects.

For example, if the MPS information include information on weld points, payload, and/or electricity requirement parameters of a robot, the correct robot tool type may be automatically selected, e.g. a weld tool gun instead of another tool gun such as e.g. a paint gun or a laser weld. Additionally, based on the weld point voltage parameter information included in the MPS information, the correct weld gun may be chosen. The robot 3D model may be reoriented to be directed towards the location where the robot needs to perform its task, e.g. the task of welding a car body recognized by weld point features derived from the CAD model of the car body.

In embodiments, the MPS information may conveniently be interpreted by means of a coded rule module whereby coded rules are defined for arranging plant objects in plant layouts, where the rule module output is a selection of suggested adjusting steps to the 3D model of the plant layout. The coded rule module may be provided with standard or specific industry rules and constraints.

In embodiments, the coded rule module may be a knowledge graph of relations among different plant object components. This knowledge graph might be generated manually or automatically so as to define relations among different components. Example of defined relations of the graph include, but it is not limited by:
- a robot having overlapping coordinates with a conveyor shall be placed above the conveyer in a feasible way;
- an electrical cabinet which is located near a wall should have its rear side placed to the wall;
- a robot which is placed near weld-points is to be equipped with a weld-gun;
- type of weld gun depending on voltage information.

In embodiments, the orientation of a 3D model of a plant object may be adjusted by using spatial information (e.g. orientate the rear side of a closet towards wall) and/or by using MPS information (e.g. turning a robot to the direction of the welding points).

Advantageously the coded rules module enables to combine information coming out from the PLM software backbone and information coming from the 2D plant layout schema in order to adjust the 3D model of the plant layout.

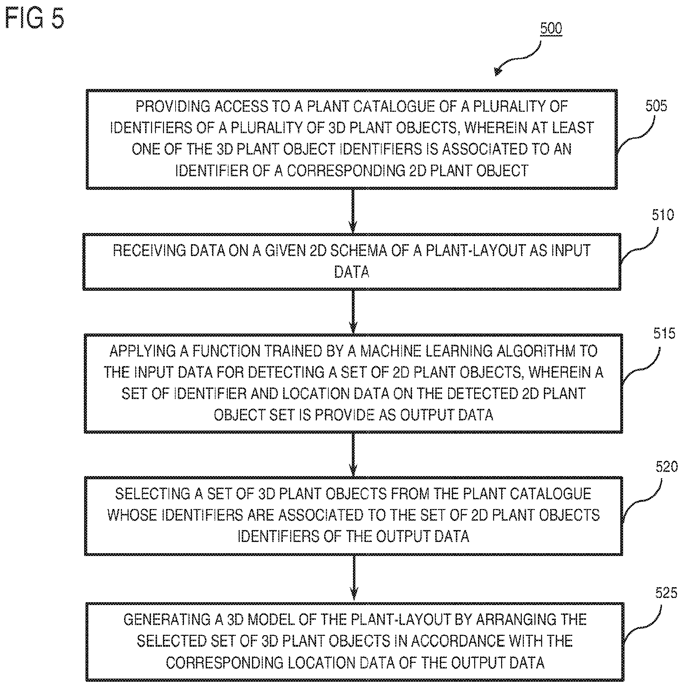

Figure 5 illustrates a flowchart 500 of a method for generating a 3D model of a plant layout in accordance with disclosed embodiments. Such method can be performed, for example, by system 100 of Figure 1 described above, but the "system" in the process below can be any apparatus configured to perform a process as described.

At act 505, access to a plant catalogue of a plurality of identifiers of a plurality of 3D plant objects is provided, wherein at least one of the 3D plant object identifiers is associated to an identifier of a corresponding 2D plant object. In embodiments, the plant catalogue is a standard catalogue, a specific catalogue or a combination of the two. In embodiments, the digital plant objects are CAD objects.

At act 510, data on a given 2D schema of a plant-layout are received as input data. In embodiments, the plant layout 2D schema comprises a set of schema annotations providing schema information. In embodiments, additional layout data are provided. Example of additional layout data includes, but is not limited by, manufacturing process semantic information.

At act 515, a function trained by a machine learning algorithm is applied to the input data for detecting a set of 2D plant objects, wherein a set of identifier and location data on the detected 2D plant object set is provide as output data.

At act 520, a set of 3D plant objects is selected from the plant catalogue whose identifiers are associated to the set of 2D plant objects identifiers of the output data.

At act 525, a 3D model of the plant-layout is generated by arranging the selected set of 3D plant objects in accordance with the corresponding location data of the output data.

In embodiments, the additional layout data and/or the schema annotation information are interpreted by a coded rule module so as to provide a selection of adjusting steps to the plant layout 3D model. In embodiments, the coded rule module is a knowledge graph..

Of course, those of skill in the art will recognize that, unless specifically indicated or required by the sequence of operations, certain steps in the processes described above may be omitted, performed concurrently or sequentially, or performed in a different order.

Those skilled in the art will recognize that, for simplicity and clarity, the full structure and operation of all data processing systems suitable for use with the present disclosure is not being illustrated or described herein. Instead, only so much of a data processing system as is unique to the present disclosure or necessary for an understanding of the present disclosure is illustrated and described. The remainder of the construction and operation of data processing system 100 may conform to any of the various current implementations and practices known in the art.

It is important to note that while the disclosure includes a description in the context of a fully functional system, those skilled in the art will appreciate that at least portions of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an exemplary embodiment of the present disclosure has been described in detail, those skilled in the art will understand that various changes, substitutions, variations, and improvements disclosed herein may be made without departing from the scope of the disclosure in its broadest form.

None of the description in the present application should be read as implying that any particular element, step, or function is an essential element which must be included in the claim scope: the scope of patented subject matter is defined only by the allowed claims.

## Claims

1. A method (500) for generating, by a data processing system (100) for manufacturing planning, a 3D-model of a plant layout departing from a 2D-schema of the plant-layout, wherein the plant-layout comprises an arrangement of a plurality of plant objects, the plant-layout being representable by a 2D-schema and by a 3D model, wherein the plant-layout 2D schema comprises a 2D arrangement of a plurality of 2D plant objects and the plant-layout 3D model comprises a 3D arrangement of a plurality of 3D plant objects; the method comprising the following steps:
a) providing (505) access to a plant catalogue of a plurality of identifiers of a plurality of 3D plant objects, wherein at least one of the 3D plant object identifiers is associated to an identifier of a corresponding 2D plant object;
b) receiving (510) data on a given 2D schema of a plant-layout as input data;
c) applying (515) a machine learning, ML, function trained by a machine learning algorithm to the input data for detecting a set of 2D plant objects, wherein a set of identifier and location data on the detected 2D plant object set is provided as output data;
d) selecting (520) a set of 3D plant objects from the plant catalogue whose identifiers are associated to the set of 2D plant objects identifiers of the output data;
e) generating (525) a 3D model of the plant-layout by arranging the selected set of 3D plant objects in accordance with the corresponding location data of the output data.

2. The method (500) of claim 1, wherein the plant layout 2D schema comprises a set of schema annotations (211-213) providing schema information.

3. The method (500) of claim 1 or 2, wherein additional layout data are provided.

4. The method (500) of claim 2 or 3, wherein the additional layout data and/or the schema annotation information are interpreted by a coded rule module so as to provide a selection of adjusting steps to the plant layout 3D model.

5. The method (500) of claim 4, wherein the coded rule module is a knowledge graph and/or the additional layout data comprise manufacturing process semantic information.

6. The method (500) of claim 1, wherein the plant catalogue is a standard catalogue, a specific catalogue or a combination of the two.

7. The method (500) of claim 1, wherein the digital plant objects are CAD objects.

8. The method (500) of claim 1, wherein the ML function has been trained with YOLO algorithm.

9. A data processing system (100) for manufacturing planning comprising:
a processor (102); and
an accessible memory, the data processing system (100) particularly configured to:
a) provide access to a plant catalogue of a plurality of identifiers of a plurality of 3D plant objects, wherein at least one of the 3D plant object identifiers is associated to an identifier of a corresponding 2D plant object;
b) receive data on a given 2D schema of a plant-layout as input data;
c) apply a machine learning, ML, function trained by a machine learning algorithm to the input data for detecting a set of 2D plant objects, wherein a set of identifier and location data on the detected 2D plant object set is provided as output data;
d) select a set of 3D plant objects from the plant catalogue whose identifiers are associated to the set of 2D plant objects identifiers of the output data;
e) generate a 3D model of the plant-layout by arranging the selected set of 3D plant objects in accordance with the corresponding location data of the output data.

10. The data processing system (100) of claim 9, wherein the plant layout 2D schema comprises a set of schema annotations (211-213) providing schema information.

11. The data processing system (100) of claim 9 or 10, wherein additional layout data are provided.

12. The data processing system (100) of claim 10 or 11, wherein the additional layout data and/or the schema annotation information are interpreted by a coded rule module so as to provide a selection of adjusting steps to the plant layout 3D model.

13. The data processing system (100) of claim 12, wherein the coded rule module is a knowledge graph and/or the additional layout data comprise manufacturing process semantic information.

14. The data processing system (100) of claim 9, wherein the plant catalogue is a standard catalogue, a specific catalogue or a combination of the two.

15. The data processing system (100) of claim 9, wherein the digital plant objects are CAD objects.

16. A non-transitory computer-readable medium encoded with executable instructions that, when executed, cause one or more data processing systems (100) for manufacturing planning to:
a) provide access to a plant catalogue of a plurality of identifiers of a plurality of 3D plant objects, wherein at least one of the 3D plant object identifiers is associated to an identifier of a corresponding 2D plant object;
b) receive data on a given 2D schema of a plant-layout as input data;
c) apply a machine learning, ML, function trained by a machine learning algorithm to the input data for detecting a set of 2D plant objects, wherein a set of identifier and location data on the detected 2D plant object set is provided as output data;
d) select a set of 3D plant objects from the plant catalogue whose identifiers are associated to the set of 2D plant objects identifiers of the output data;
e) generate a 3D model of the plant-layout by arranging the selected set of 3D plant objects in accordance with the corresponding location data of the output data.

17. The non-transitory computer-readable medium of claim 16, wherein the plant layout 2D schema comprises a set of schema annotations (211-213) providing schema information.

18. The non-transitory computer-readable medium of claim 16, wherein additional layout data are provided.

## Patentansprüche

1. Verfahren (500) zum Generieren eines 3D-Modells von einem Anlagenlayout ausgehend von einem 2D-Schema des Anlagenlayouts durch ein Datenverarbeitungssystem (100) für die Produktionsplanung, wobei das Anlagenlayout eine Anordnung mehrerer Anlagenobjekte umfasst, wobei das Anlagenlayout durch ein 2D-Schema und ein 3D-Modell darstellbar ist, wobei das 2D-Schema von dem Anlagenlayout eine 2D-Anordnung mehrerer 2D-Anlagenobjekte und das 3D-Modell von dem Anlagenlayout eine 3D-Anordnung mehrerer 3D-Anlagenobjekte umfasst, wobei das Verfahren folgende Schritte umfasst:
a) Ermöglichen (505) eines Zugriffs auf einen Anlagenkatalog aus mehreren Kennungen für mehrere 3D-Anlagenobjekte, wobei mindestens eine der 3D-Anlagenobjektkennungen mit einer Kennung für ein entsprechendes 2D-Anlagenobjekt verknüpft ist,
b) Empfangen (510) von Daten zu einem gegebenen 2D-Schema von einem Anlagenlayout als Eingabedaten,
c) Anwenden (515) einer Maschinenlernfunktion, ML-Funktion, die mit einem Maschinenlernalgorithmus trainiert wird, auf die Eingabedaten zwecks Erkennens einer Reihe von 2D-Anlagenobjekten, wobei eine Reihe von Kenn- und Standortdaten zu der erkannten Reihe von 2D-Anlagenobjekten als Ausgabedaten bereitgestellt wird,
d) Auswählen (520) einer Reihe von 3D-Anlagenobjekten aus dem Anlagenkatalog, deren Kennungen mit der Reihe von 2D-Anlagenobjektkennungen in den Ausgabedaten verknüpft sind,
e) Generieren (525) eines 3D-Modells von dem Anlagenlayout durch Anordnen der ausgewählten Reihe von 3D-Anlagenobjekten gemäß den entsprechenden Standortdaten in den Ausgabedaten.

2. Verfahren (500) nach Anspruch 1, wobei das 2D-Schema von dem Anlagenlayout eine Reihe von Anmerkungen zum Schema (211-213) umfasst, die Informationen zum Schema bereitstellen.

3. Verfahren (500) nach Anspruch 1 oder 2, wobei zusätzliche Layoutdaten bereitgestellt werden.

4. Verfahren (500) nach Anspruch 2 oder 3, wobei die zusätzlichen Layoutdaten und/oder die Informationen in den Anmerkungen zum Schema von einem Modul mit einprogrammierten Regeln interpretiert werden und so eine Auswahl von Anpassungsschritten für das 3D-Modell von dem Anlagenlayout bereitgestellt wird.

5. Verfahren (500) nach Anspruch 4, wobei es sich bei dem Modul mit einprogrammierten Regeln um ein Wissensdiagramm handelt und/oder die zusätzlichen Layoutdaten semantische Informationen zum Produktionsprozess umfassen.

6. Verfahren (500) nach Anspruch 1, wobei es sich bei dem Anlagenkatalog um einen Standardkatalog, einen Spezialkatalog oder eine Kombination aus beidem handelt.

7. Verfahren (500) nach Anspruch 1, wobei es sich bei den digitalen Anlagenobjekten um CAD-Objekte handelt.

8. Verfahren (500) nach Anspruch 1, wobei die ML-Funktion mit einem YOLO-Algorithmus trainiert wurde.

9. Datenverarbeitungssystem (100) für die Produktionsplanung, das Folgendes umfasst:
einen Prozessor (102) und
einen verfügbaren Speicher, wobei das Datenverarbeitungssystem (100) insbesondere so konfiguriert ist, dass es:
a) Zugriff auf einen Anlagenkatalog aus mehreren Kennungen für mehrere 3D-Anlagenobjekte ermöglicht, wobei mindestens eine der 3D-Anlagenobjektkennungen mit einer Kennung für ein entsprechendes 2D-Anlagenobjekt verknüpft ist,
b) Daten zu einem gegebenen 2D-Schema von einem Anlagenlayout als Eingabedaten empfängt,
c) zwecks Erkennens einer Reihe von 2D-Anlagenobjekten eine Maschinenlernfunktion, ML-Funktion, die mit einem Maschinenlernalgorithmus trainiert wird, auf die Eingabedaten anwendet, wobei eine Reihe von Kenn- und Standortdaten zu der erkannten Reihe von 2D-Anlagenobjekten als Ausgabedaten bereitgestellt wird,
d) eine Reihe von 3D-Anlagenobjekten aus dem Anlagenkatalog auswählt, deren Kennungen mit der Reihe von 2D-Anlagenobjektkennungen in den Ausgabedaten verknüpft sind,
e) durch Anordnen der ausgewählten Reihe von 3D-Anlagenobjekten gemäß den entsprechenden Standortdaten in den Ausgabedaten ein 3D-Modell von dem Anlagenlayout generiert.

10. Datenverarbeitungssystem (100) nach Anspruch 9, wobei das 2D-Schema von dem Anlagenlayout eine Reihe von Anmerkungen zum Schema (211-213) umfasst, die Informationen zum Schema bereitstellen.

11. Datenverarbeitungssystem (100) nach Anspruch 9 oder 10, wobei zusätzliche Layoutdaten bereitgestellt werden.

12. Datenverarbeitungssystem (100) nach Anspruch 10 oder 11, wobei die zusätzlichen Layoutdaten und/oder die Informationen in den Anmerkungen zum Schema von einem Modul mit einprogrammierten Regeln interpretiert werden und so eine Auswahl von Anpassungsschritten für das 3D-Modell von dem Anlagenlayout bereitgestellt wird.

13. Datenverarbeitungssystem (100) nach Anspruch 12, wobei es sich bei dem Modul mit einprogrammierten Regeln um ein Wissensdiagramm handelt und/oder die zusätzlichen Layoutdaten semantische Informationen zum Produktionsprozess umfassen.

14. Datenverarbeitungssystem (100) nach Anspruch 9, wobei es sich bei dem Anlagenkatalog um einen Standardkatalog, einen Spezialkatalog oder eine Kombination aus beidem handelt.

15. Datenverarbeitungssystem (100) nach Anspruch 9, wobei es sich bei den digitalen Anlagenobjekten um CAD-Objekte handelt.

16. Nichtflüchtiges, computerlesbares Medium, das mit ausführbaren Anweisungen codiert ist, die, wenn sie ausgeführt werden, bewirken, dass ein oder mehrere Datenverarbeitungssysteme (100) für die Produktionsplanung:
a) Zugriff auf einen Anlagenkatalog aus mehreren Kennungen für mehrere 3D-Anlagenobjekte ermöglichen, wobei mindestens eine der 3D-Anlagenobjektkennungen mit einer Kennung für ein entsprechendes 2D-Anlagenobjekt verknüpft ist,
b) Daten zu einem gegebenen 2D-Schema von einem Anlagenlayout als Eingabedaten empfangen,
c) zwecks Erkennens einer Reihe von 2D-Anlagenobjekten eine Maschinenlernfunktion, ML-Funktion, die mit einem Maschinenlernalgorithmus trainiert wird, auf die Eingabedaten anwenden, wobei eine Reihe von Kenn- und Standortdaten zu der erkannten Reihe von 2D-Anlagenobjekten als Ausgabedaten bereitgestellt wird,
d) eine Reihe von 3D-Anlagenobjekten aus dem Anlagenkatalog auswählen, deren Kennungen mit der Reihe von 2D-Anlagenobjektkennungen in den Ausgabedaten verknüpft sind,
e) durch Anordnen der ausgewählten Reihe von 3D-Anlagenobjekten gemäß den entsprechenden Standortdaten in den Ausgabedaten ein 3D-Modell von dem Anlagenlayout generieren.

17. Nichtflüchtiges, computerlesbares Medium nach Anspruch 16, wobei das 2D-Schema von dem Anlagenlayout eine Reihe von Anmerkungen zum Schema (211-213) umfasst, die Informationen zum Schema bereitstellen.

18. Nichtflüchtiges, computerlesbares Medium nach Anspruch 16, wobei zusätzliche Layoutdaten bereitgestellt werden.

## Revendications

1. Procédé (500) de génération, par un système de traitement de données (100) pour la planification de fabrication, d'un modèle tridimensionnel (3D) d'une implantation d'usine à partir d'un schéma bidimensionnel (2D) de l'implantation d'usine, dans lequel l'implantation d'usine comprend un agencement d'une pluralité d'objets d'usine, l'implantation d'usine pouvant être représentée par un schéma 2D et par un modèle 3D, dans lequel le schéma 2D de l'implantation d'usine comprend un agencement 2D d'une pluralité d'objets d'usine 2D et le modèle 3D d'implantation d'usine comprend un agencement 3D d'une pluralité d'objets d'usine 3D ; le procédé comprenant les étapes suivantes :
a) fournir (505) l'accès à un catalogue d'usine d'une pluralité d'identifiants d'une pluralité d'objets d'usine 3D, dans lequel au moins un des identifiants d'objets d'usine 3D est associé à un identifiant d'un objet d'usine 2D correspondant ;
b) recevoir (510) des données sur un schéma 2D donné d'une implantation d'usine en tant que données d'entrée ;
c) appliquer (515) une fonction d'apprentissage automatique, ML, entraînée par un algorithme d'apprentissage automatique aux données d'entrée pour détecter un ensemble d'objets d'usine 2D, dans lequel un ensemble de données d'identifiant et de localisation sur l'ensemble d'objets d'usine 2D détecté est fourni en tant que données de sortie ;
d) sélectionner (520) un ensemble d'objets d'usine 3D à partir du catalogue d'usine dont les identifiants sont associés à l'ensemble d'identifiants d'objets d'usine 2D des données de sortie ;
e) générer (525) un modèle 3D de l'implantation d'usine en agençant l'ensemble sélectionné d'objets d'usine 3D conformément aux données de localisation correspondantes des données de sortie.

2. Procédé (500) selon la revendication 1, dans lequel le schéma 2D d'implantation d'usine comprend un ensemble d'annotations de schéma (211-213) fournissant des informations de schéma.

3. Procédé (500) selon la revendication 1 ou 2, dans lequel des données d'implantation supplémentaires sont fournies.

4. Procédé (500) selon la revendication 2 ou 3, dans lequel les données d'implantation supplémentaires et/ou les informations d'annotation de schéma sont interprétées par un module de règles codées afin de fournir une sélection d'étapes d'ajustement au modèle 3D d'implantation d'usine.

5. Procédé (500) selon la revendication 4, dans lequel le module de règles codées est un graphe de connaissances et/ou les données d'implantation supplémentaires comprennent des informations sémantiques sur le processus de fabrication.

6. Procédé (500) selon la revendication 1, dans lequel le catalogue d'usine est un catalogue standard, un catalogue spécifique ou une combinaison des deux.

7. Procédé (500) selon la revendication 1, dans lequel les objets numériques d'usine sont des objets CAD.

8. Procédé (500) selon la revendication 1, dans lequel la fonction ML a été entraînée avec l'algorithme YOLO.

9. Système de traitement de données (100) pour la planification de fabrication, comprenant :
un processeur (102) ; et
une mémoire accessible, le système de traitement de données (100) étant particulièrement configuré pour :
a) fournir l'accès à un catalogue d'usine d'une pluralité d'identifiants d'une pluralité d'objets d'usine 3D, dans lequel au moins un des identifiants d'objets d'usine 3D est associé à un identifiant d'un objet d'usine 2D correspondant ;
b) recevoir des données sur un schéma 2D donné d'une implantation d'usine en tant que données d'entrée ;
c) appliquer une fonction d'apprentissage automatique, ML, entraînée par un algorithme d'apprentissage automatique aux données d'entrée pour détecter un ensemble d'objets d'usine 2D, dans lequel un ensemble de données d'identifiant et de localisation sur l'ensemble d'objets d'usine 2D détecté est fourni en tant que données de sortie ;
d) sélectionner un ensemble d'objets d'usine 3D à partir du catalogue d'usine dont les identifiants sont associés à l'ensemble d'identifiants d'objets d'usine 2D des données de sortie ;
e) générer un modèle 3D de l'implantation d'usine en agençant l'ensemble sélectionné d'objets d'usine 3D conformément aux données de localisation correspondantes des données de sortie.

10. Système de traitement de données (100) selon la revendication 9, dans lequel le schéma 2D d'implantation d'usine comprend un ensemble d'annotations de schéma (211-213) fournissant des informations de schéma.

11. Système de traitement de données (100) selon la revendication 9 ou 10, dans lequel des données d'implantation supplémentaires sont fournies.

12. Système de traitement de données (100) selon la revendication 10 ou 11, dans lequel les données d'implantation supplémentaires et/ou les informations d'annotation de schéma sont interprétées par un module de règles codées afin de fournir une sélection d'étapes d'ajustement au modèle 3D d'implantation d'usine.

13. Système de traitement de données (100) selon la revendication 12, dans lequel le module de règles codées est un graphe de connaissances et/ou les données d'implantation supplémentaires comprennent des informations sémantiques sur le processus de fabrication.

14. Système de traitement de données (100) selon la revendication 9, dans lequel le catalogue d'usine est un catalogue standard, un catalogue spécifique ou une combinaison des deux.

15. Système de traitement de données (100) selon la revendication 9, dans lequel les objets numériques d'usine sont des objets CAD.

16. Support non transitoire lisible par ordinateur codé avec des instructions exécutables qui, lorsqu'elles sont exécutées, amènent un ou plusieurs systèmes de traitement de données (100) pour la planification de fabrication à :
a) fournir l'accès à un catalogue d'usine d'une pluralité d'identifiants d'une pluralité d'objets d'usine 3D, dans lequel au moins un des identifiants d'objets d'usine 3D est associé à un identifiant d'un objet d'usine 2D correspondant ;
b) recevoir des données sur un schéma 2D donné d'une implantation d'usine en tant que données d'entrée ;
c) appliquer une fonction d'apprentissage automatique, ML, entraînée par un algorithme d'apprentissage automatique aux données d'entrée pour détecter un ensemble d'objets d'usine 2D, dans lequel un ensemble de données d'identifiant et de localisation sur l'ensemble d'objets d'usine 2D détecté est fourni en tant que données de sortie ;
d) sélectionner un ensemble d'objets d'usine 3D à partir du catalogue d'usine dont les identifiants sont associés à l'ensemble d'identifiants d'objets d'usine 2D des données de sortie ;
e) générer un modèle 3D de l'implantation d'usine en agençant l'ensemble sélectionné d'objets d'usine 3D conformément aux données de localisation correspondantes des données de sortie.

17. Support non transitoire lisible par ordinateur selon la revendication 16, dans lequel le schéma 2D d'implantation d'usine comprend un ensemble d'annotations de schéma (211-213) fournissant des informations de schéma.

18. Support non transitoire lisible par ordinateur selon la revendication 16, dans lequel des données d'implantation supplémentaires sont fournies.
